# EUROPEAN PATENT SPECIFICATION

(11) **EP 3 139 718 B1**
(45) Date of publication and mention of the grant of the patent: **30.10.2024**
(21) Application number: 15183729.1
(22) Date of filing: 03.09.2015
(51) Int. Cl.: H05K 9/00

(54) **HOUSING FOR ENCLOSING AT LEAST ONE ELECTRICAL COMPONENT OF A MOTOR VEHICLE, AND METHOD OF MOUNTING A HOUSING**
GEHÄUSE ZUR UMHÜLLUNG VON MINDESTENS EINER ELEKTRISCHEN KOMPONENTE EINES KRAFTFAHRZEUGS UND VERFAHREN ZUR MONTAGE EINES GEHÄUSES
BOÎTIER POUR ENFERMER AU MOINS UN COMPOSANT ÉLECTRIQUE D'UN VÉHICULE AUTOMOBILE ET PROCÉDÉ DE MONTAGE D'UN BOÎTIER

(43) Date of publication of application: 08.03.2017
(73) Proprietor: Magna Electronics Sweden AB, 447 37 Vårgårda (SE)
(72) Inventor: Wigren, Roger, 59074 Ljungsbro (SE); Gunes, Melih, Wixom, MI 48393 (US)
(74) Representative: Müller Verweyen

(56) References cited:
- EP-A2- 2 802 200
- EP-B1- 2 416 926
- DE-A1- 102005 038 608
- RU-U1- 109 338

## Description

The invention relates to a housing for enclosing at least one electrical component of a motor vehicle, comprising at least a first metal housing part with a first circumferential connection surface and a second housing part with a second circumferential connection surface, wherein said metal housing parts are designed to be connected to each other along a connection direction such that said first circumferential connection surface and said second circumferential connection surfaces lie face to face to each other in the connected state. The invention also relates to a method of mounting such a housing.

Camera devices of a vision system for a motor vehicle are usually protected by a metal housing. The housing should not only give a protection against mechanical stress or damage, but also shield against electromagnetic waves. However, when the housing is put together by two or more housing parts, the Faraday cage built by the housing parts may have gaps at the connection surfaces of the housing parts. In such case electromagnetic waves could penetrate into the housing and cause a malfunction of the electrical components inside the housing. Also, electromagnetic waves originating from the electrical components inside the housing could penetrate to the exterior of the housing and cause malfunctions of other electrical devices in the motor vehicle.

EP 2 802 200 A2 discloses a housing according to the preamble of claim 1.

The problem underlying the present invention is to provide a fail-safe Faraday cage giving a better protection and shielding against electromagnetic waves for electrical components inside and outside the housing.

The invention solves this object with the features of the independent claims. Cooperating first and second metal housing parts each have circumferential connection surfaces and the metal housing parts are designed to be connected to each other along the connection surfaces such that said circumferential connection surfaces lie face to face to each other in the connected state of the housing parts. According to the invention, at least one of the housing parts comprises a plurality of cutting elements protruding from the corresponding circumferential connection surface. At least a part of the cutting elements has an oversize with respect to the other circumferential connection surface, such that said cutting elements cut into the other circumferential connection surface during connection of the housing parts. The cutting elements are distributed over the circumference of the circumferential connection surface. The cutting elements of the invention generate metal to metal contact points distributed over the circumference of the circumferential connection surface, and thus close the Faraday cage built by the housing parts, bridging the gap between the first and the second housing part so that no electromagnetic waves can penetrate into or out from the housing.

In order to achieve a good fit between the first and the second metal housing part, the circumferential connection surfaces of the first and the second housing parts are advantageously oriented parallel to the connection direction, so that the connection can be achieved by a simple translational motion.

According to the invention, the cutting elements have a longitudinal axis oriented parallel to the connection surfaces of the first and the second metal housing part. In this case there is no lateral force pushing one of the metal housing parts away from the connection direction and a fixing of both housing parts by a simple translational motion is possible.

According to the invention, the cutting elements are tapering in the connection direction in a view onto the corresponding circumferential surface. Therefore a force during the connecting process increases when the first and the second metal housing part are connected, so that the connecting process can be reliably controlled.

According to the invention, the cutting elements are arranged with a distance to a front edge of the corresponding metal housing part which comes first into contact with said other metal housing part during the connection of the housing parts. As a result, the edge of the one metal housing part can be used as a centering means during connecting both metal housing parts, which eases the connecting process.

According to the invention, a front part of said cutting elements has an undersize with respect to the other circumferential connection surface. Therefore the front part of the cutting elements will fit easily in the other metal housing part. The connection will be strengthened when a back part of the cutting elements on one of the metals housing parts provide an advantageous press-fit with the circumferential connection surface of the other metal housing part.

In a preferred embodiment of the invention at least one of the metal housing parts has a planar surface so that the cutting elements on one of the metal housing parts can scratch or cut into said planar surface of the other metal housing part.

Preferably the housing parts are made of aluminum. Aluminum has a comparably light weight and a high electrical conductivity and is therefore a preferred material for the housing parts. More preferably the housing parts are made of die-cast aluminum as a die cast process allows to build a complex geometry on the housing parts including the circumferential connection surfaces as well as the cutting elements. The manufacturing tolerances of a die-cast aluminum are sufficient to reach the tolerances for components such as housings.

According to the invention, tapering of the cutting elements avoids high forces in the first state of the connection process. The oversize of the rear part of the cutting elements with respect to the circumferential connection surface of the second metal housing part allows a safe and reliable press-fitting when the rear part of the cutting elements cut into the surface of the other housing part. The surface of the cutting elements should have a relatively small angle with the longitudinal axis through the cutting elements to avoid high forces when the housing parts are connected. To build up a fail-safe Faraday cage the length of the cutting elements is preferable between 2 mm and 15 mm, more preferable between 5 mm and 10mm.

In a preferred embodiment of the invention the cutting elements are spaced from each other by a distance of not more than 50 mm, preferably not more than 35 mm, more preferably not more than 20 mm. A highly efficient Faraday cage protects against high-frequency alternating fields, because on the surface of the cage eddy currents are induced which counteract the external field. The shielding effect is in this case characterized by finite shielding attenuation and penetration into the housing so that the electronic components inside the housing are protected. Smaller distances between the cutting elements are generally preferred as the penetration gets smaller and the shielding effect more reliable.

According to the invention, the cutting elements have a maximum thickness which is larger than a gap between the circumferential connection surfaces in the connected stated of the metal housing parts. Therefore the cutting elements fit into the other housing part with a press-fitting, scratching or cutting action into the circumferential connection surface, thus penetrating any passivation layer of an aluminum housing part. Herein, the thickness of the cutting elements is measured in a non-connected state of the housing parts.

According to the invention the cutting elements are spike-shaped. Such shape is to cut into the other housing part, penetrate a passivation layer and build up a Faraday cage.

In the following the invention shall be illustrated on the basis of preferred embodiments with reference to the accompanying drawings, wherein:
- Fig. 1: shows a schematic drawing of a metal housing according to the invention, wherein the housing parts are shown in a non-connected state;
- Fig. 2: shows a schematic drawing of a metal housing according to the invention, wherein the housing parts are shown in a connected state;
- Fig. 3: shows a perspective view on a first housing part according to the invention;
- Fig. 4: shows a view on the rear side of the first housing part of Fig. 3; and
- Fig. 5: shows a detailed side view of a cutting element in a cross section through the first housing part of Figs. 3 and 4.

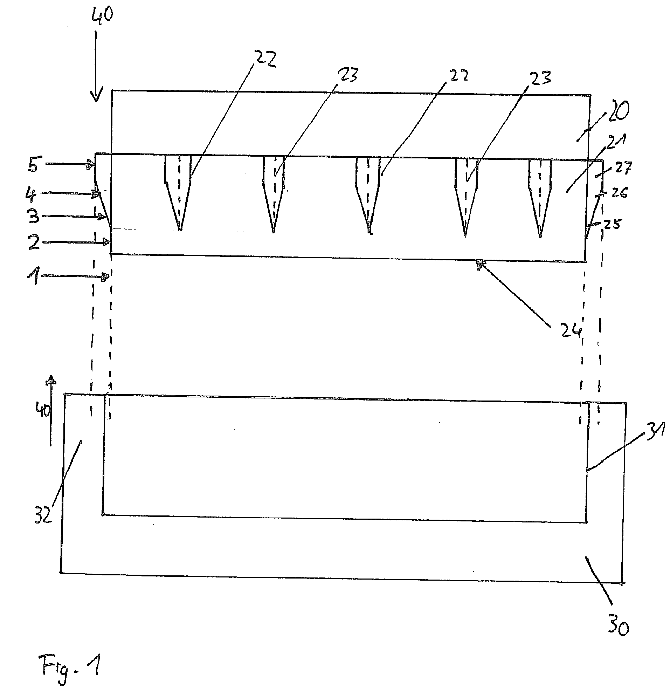

Fig. 1 shows a housing 10 for enclosing at least one electronic component of a motor vehicle, such as one or more camera modules not shown in the figures. The housing 10 comprises a first metal housing part 20 with a first circumferential connection surface 21 and a second metal housing part 30 with a second circumferential connection surface 31. The circumferential connection surfaces 21, 31 of the metal housing parts 20, 30 are planar surfaces. The first metal housing part 20 and the second metal housing part 30 are designed to be connected to each other along a connection direction 40 such that the circumferential connection surfaces 21, 31 lie face to face to each other in a connected state of those metal housing parts 20, 30.

The first metal housing part 20 comprises a plurality of cutting elements 22 protruding from the planar surface of the circumferential connection surface 21. The cutting elements 21 are arranged with a distance to a front edge 24 of the first metal housing part 20. The cutting elements 22 have a length of 2 mm to 15 mm, preferably between 5 mm to 10 mm. Each cutting element has a front part 25, a rear part 26 and may have a straight part 27. The front part 25 has an undersize with respect to the circumferential connection surface 31 of the second metal housing part 30 and the rear part 26 has an oversize with respect to the circumferential connection surface 31 of the second metal housing part 30. The straight part 27 can also have an oversize with respect to the circumferential connection surface 31.

The cutting elements 22 are equally spaced along the circumferential connection surfaces 21, 31, preferably by a distance of not more than 50 mm, preferably not more than 35 mm, more preferably not more than 20 mm relative to each other. The cutting elements 22 have a spike-shape.

The connection direction 40 is shown with arrows alongside the both metal housing parts 20, 30 in Fig. 1. The numbers 1 to 5 relate to different states of the connection process, starting from a non-connected state 1 to a fully connected state 5. In state 2 the front edge 24 of the first metal housing 20 dives into the second metal housing part 30 and there is no contact, as the front edge 24 of the first metal housing part 20 has an undersize with respect to a collar 32 of the second metal housing part 30. In state 3 the front parts 25 of the cutting elements 22 dive into the collar 32 of the second metal housing part 30 until the cutting elements 22 get in touch with the connection surface 31 of the second metal housing part 30. In state 4 the rear part 26 of the cutting elements 22 cut into the connection surface 31 of second metal housing part 30. Following state 4 the straight part 27 of the cutting elements 27 come into press-fit contact with the connection surface 31 until a fully connected state 5 is reached.

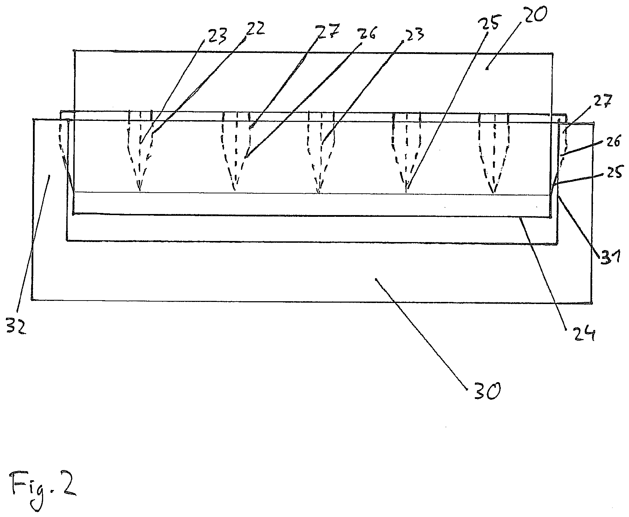

Fig. 2 shows the housing 10 with the first metal housing part 20 and the second metal housing part 30 in a fully connected state corresponding to level 5 in Fig. 1, wherein at least the rear parts 26 and, if present, the straight parts 27 of the cutting elements 22 have an oversize with respect to the circumferential connection surface 31 of the second housing part 30.

The circumferential connection surfaces 21, 31 are orientated parallel to the connection direction 40 of the metal housing parts 20, 30. The first metal housing part 20 and the second metal housing part 30 provide a press fitting along the cutting elements 22 when both metal housing parts 20, 30 are connected to each other. The metal housing parts 20, 30 thus build a Faraday cage along the circumferential connection surfaces 21, 31, such that the cutting elements 22 close a gap between the two metal housing parts 20, 30. A maximum thickness of the cutting elements 22 is larger than a gap between the circumferential connecting surfaces 21, 31 in the connected state of the first metal housing part 20 and the second metal housing part 30.

The metal housing parts 20, 30 not only provide mechanical protection but also shielding against electromagnetic waves to electronic components inside and outside the housing 10. The cutting elements 22 have a longitudinal axis 23 which is orientated parallel to the connection direction of the two housing parts 20, 30. The cutting elements 22 are tapering in the connection direction in a view onto the corresponding circumferential connection surface 21 and in a view along the corresponding circumferential connection surface 21.

The metal housing parts 20, 30 are made of an electrical conductive material such as aluminum, preferable die-cast aluminum, and built in a casting process. Therefore the metal housing parts 20, 30 and the cutting elements 22 are advantageously made from the same material.

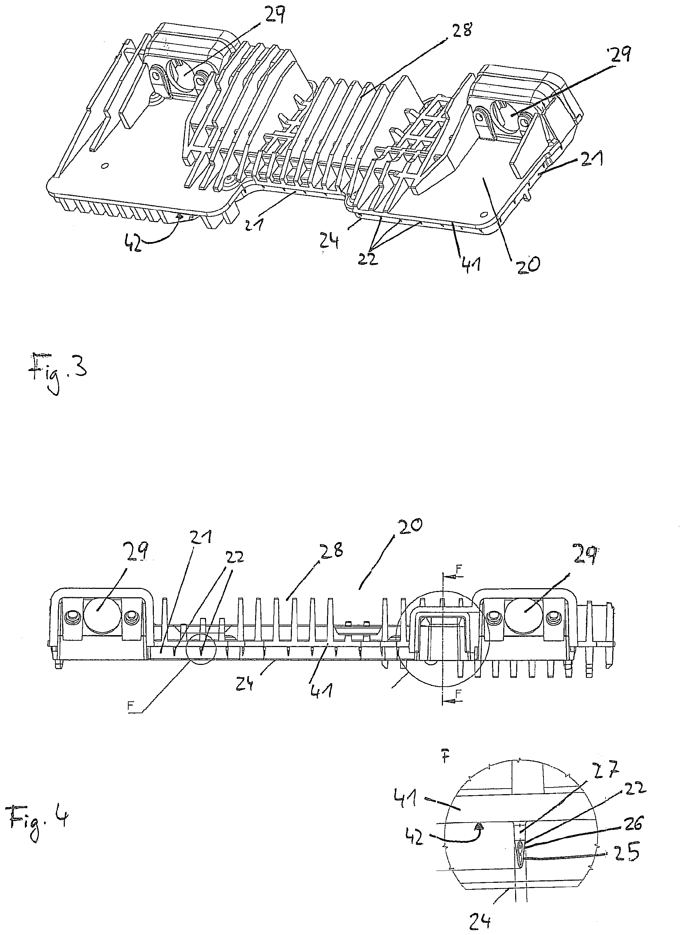

Figs. 3 to 5 show different views of a practical embodiment of a first housing part 20. The first metal housing part 20 has an opening 29 for receiving a camera module, and ribs 28, such as cooling ribs or reinforcing ribs. The first metal housing part 20 has a circumferential connection surface 21 with a planar base. A plurality of cutting elements 22 is distributed over the circumference of said circumferential connection surface 21 and protrudes from said planar base. The cutting elements 22 are equidistantly spaced over the circumference of the connection surface 21, with a distance of 8 to 10 mm between one cutting element 22 and an adjacent cutting element 22. The first housing part 20 has a preferably circumferential flange 41, which can be used as a stop surface 42 when the first housing part 20 and the second housing part 30 are connected.

The detail F of Fig. 4 shows an enlarged view onto one of the cutting elements 22. The cutting element 22 is tapering and has a front part 25 with is smaller and thinner than a rear part 26. The detail F also shows an enlarge view onto the flange 41 and the stop surface 42. Therefore the level of the fully connected state 5 can also lie on a level, where a front edge of the second housing part 30 gets in contact with the stop surface 42 of the flange 41 of the first housing part 20.

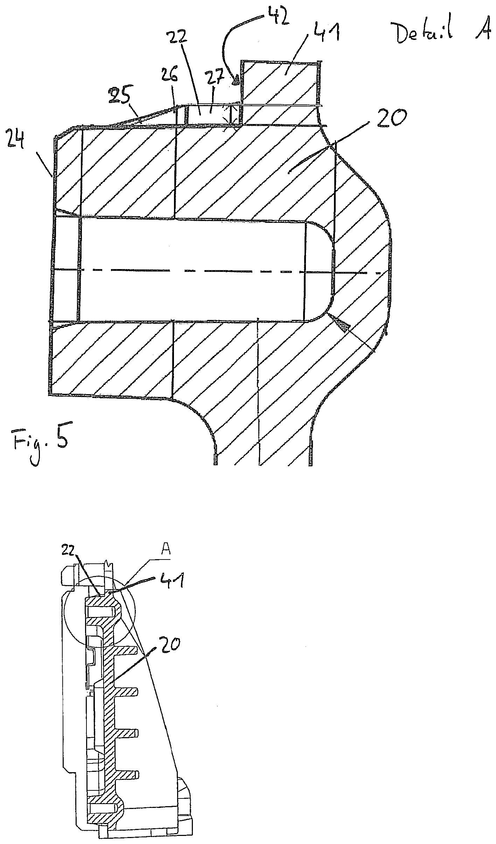

Fig. 5 shows an enlarged cross sectional view of the first metal housing part 20. As shown in Fig. 5 the cutting element 22 is distanced from the front edge 24 of the first metal housing part 20 and has a front part 25, a rear part 26 and a straight part 27. The straight part 27 extends to the preferably circumferential flange 41, so the stop surface 42 can build a stop for the front edge of the second housing part when the two housing parts 20, 30 are connected in the connection direction 40.

When the housing 10 is mounted the first metal housing part 10 and the second metal housing part 20 are connected along a connection direction, the circumferential connection surfaces 21, 31 being oriented parallel to the connection direction. When the front edge 24 of the first housing part 20 dives into a collar 9 of the second housing part 30 there is a gap between those two housing parts 20, 30. The front parts 25 of the cutting elements 22 on the circumferential connection surface 21 of the first metal housing part 20 have an undersize with respect to the other circumferential connection surface 31 of the second metal housing part 30. Due to the tapered shape of the cutting elements 22 and the fact that the cutting elements 22 have a thickness that is larger than the gap between the two metal housing parts 20, 30 in a connected state, the rear part 26 of each cutting element 22 scratches or cuts into the other circumferential connection surface 31. The cutting elements 22 thus penetrate a passivation layer on the aluminum of the second metal housing part 30. Furthermore, when the two metal housing parts 20, 30 are connected in the fully connected state, the straight parts 27 of the cutting elements 22 are in press-fit contact with the connection surface 31 of the second metal housing part 30 and thus form a tight connection of the two metal housing parts 20, 30. The stop surface 42 can assist in a connection process so that the fully connected state 5 is not only defined by a force for the press fitting connection but also by a defined stop.

Generally it is possible to have cutting elements 22 not only on one housing part, here the first metal housing part 20, but on both housing parts, here also on the second metal housing part 30. In an embodiment not shown, the cutting elements 22 can be distributed alternating on both metal housing parts 20, 30 so that the cutting elements 22 on the first metal housing part cut into the planar part of the second circumferential connection surface 31 of the second metal housing part and the cutting elements 22 on the second metal housing part 30 cut into the planar part of the first circumferential connection surface 21 of the first metal housing part 20.

## Claims

1. A housing (10) for enclosing at least one electronic component of a motor vehicle, comprising at least a first metal housing part (20) with a first circumferential connection surface (21) and a second metal housing part (30) with a second circumferential connection surface (31), wherein said metal housing parts (20, 30) are designed to be connected to each other along a connection direction such that said circumferential connection surfaces (21, 31) lie face to face to each other in the connected state,
wherein at least one of the housing parts (20) comprises a plurality of cutting elements (22) protruding from the corresponding circumferential connection surface (21), wherein at least a part of said cutting elements (22) have an oversize with respect to said other circumferential connection surface (31), such that said cutting elements (22) cut into said other circumferential connection surface (31) during connection of the housing parts (20, 30), wherein said plurality of cutting elements (22) are distributed over the circumference of said circumferential connection surfaces (21, 31),
wherein said cutting elements (22) have a longitudinal axis (23) oriented parallel to said connection direction,
wherein the cutting elements (22) have a maximum thickness which is larger than a gap between the circumferential connection surfaces (21, 31) in the connected state of the housing parts (20, 30),
wherein said cutting elements (22) are arranged with a distance to a front edge (24) of the corresponding housing part (20) which comes first into contact with said other housing part (30) during the connection of the housing parts (20, 30),
and each cutting element has a front part (25) and a rear part (26), the front part (25) has an undersize with respect to the circumferential connection surface (31) of the second metal housing part (30) and the rear part (26) has an oversize with respect to the circumferential connection surface (31) of the second metal housing part (30),
wherein the cutting elements (22) are tapering in the connection direction in a view along the corresponding circumferential connection surface (21),
**characterized in that**
the cutting elements (22) are tapering in the connection direction in a view onto the corresponding circumferential connection surface (21) and the cutting elements (22) have a spike-shape.

2. The housing (10) according to claim 1, wherein said circumferential connection surfaces (21, 31) are oriented parallel to said connection direction.

3. The housing (10) according to any one of the preceding claims, wherein said circumferential connection surface (21, 31) is a planar surface of one of the housing parts (20, 30).

4. The housing (10) as claimed in any one of the preceding claims, wherein said housing parts (20, 30) are made of aluminum, preferable die-cast aluminum.

5. The housing (10) according to any one of the preceding claims, wherein said cutting elements (22) have a length between 2 mm to 20 mm.

6. The housing (10) according to any one of the preceding claims, wherein said cutting elements (22) are equally spaced along said circumferential connection surfaces (21, 31).

7. The housing (10) according to any one of the preceding claims, wherein said cutting elements (22) are spaced from each other by a distance of not more than 50 mm.

8. A method of mounting a housing (10) according to any one of the preceding claims to enclose at least one electronic component of a motor vehicle comprising at least a first housing part (20) with a first circumferential connection surface (21) and a second housing part (30) with a second circumferential connection surface (31), comprising connecting said housing parts (20, 30) such that the circumferential connection surfaces (21, 31) are contacting each other face to face in the connected state, wherein at least one of the housing parts (20, 30) comprises a plurality of cutting elements (22) which scratch into the surface of the corresponding other circumferential connection surface (21, 31) of the other housing part (20, 30) during connection.

## Patentansprüche

1. Ein Gehäuse (10) zur Umhüllung von mindestens einer elektronischen Komponente eines Kraftfahrzeugs, wobei das Gehäuse mindestens ein erstes Metallgehäuseteil (20) mit einer ersten Umfangsverbindungsoberfläche (21) und ein zweites Metallgehäuseteil (30) mit einer zweiten Umfangsverbindungsoberfläche (31) umfasst, wobei die Metallgehäuseteile (20, 30) dafür ausgelegt sind, entlang einer Verbindungrichtung in der Weise miteinander verbunden zu werden, dass die Umfangsverbindungsoberflächen (21, 31) in dem verbundenen Zustand einander gegenüberliegen, wobei mindestens eines der Gehäuseteile (20) mehrere Schneidelemente (22) umfasst, die von der entsprechenden Umfangsverbindungsoberfläche (21) vorstehen, wobei mindestens ein Teil der Schneidelemente (22) in Bezug auf die andere Umfangsverbindungsoberfläche (31) eine Übergröße aufweisen, sodass die Schneidelemente (22) während des Verbindens der Gehäuseteile (20, 30) in die andere Umfangsverbindungsoberfläche (31) schneiden, wobei die mehreren Schneidelemente (22) über den Umfang der Umfangsverbindungsoberflächen (21, 31) verteilt sind,
wobei die Schneidelemente (22) eine Längsachse (23) aufweisen, die parallel zu der Verbindungsrichtung orientiert ist,
wobei die Schneideelemente (22) in dem verbundenen Zustand der Gehäuseteile (20, 30) eine maximale Dicke aufweisen, die größer als ein Zwischenraum zwischen den Umfangsverbindungsoberflächen (21, 31) ist,
wobei die Schneidelemente (22) mit einem Abstand zu einem vorderen Rand (24) des entsprechenden Gehäuseteils (20), der während der Verbindung der Gehäuseteile (20, 30) mit dem anderen Gehäuseteil (30) zuerst in Kontakt gelangt, angeordnet sind,
wobei jedes Schneidelement einen vorderen Teil (25) und einen hinteren Teil (26) aufweist, wobei der vordere Teil (25) in Bezug auf die Umfangsverbindungsoberfläche (31) des zweiten Metallgehäuseteils (30) eine Untergröße aufweist und der hintere Teil (26) in Bezug auf die Umfangsverbindungsoberfläche (31) des zweiten Metallgehäuseteils (30) eine Übergröße aufweist,
wobei die Schneidelemente (22) in der Verbindungsrichtung entlang der entsprechenden Umfangsverbindungsoberfläche (21) gesehen verjüngt sind,
**dadurch gekennzeichnet, dass**
die Schneidelemente (22) in der Verbindungsrichtung auf die entsprechende Umfangsverbindungsoberfläche (21) gesehen verjüngt sind und die Schneidelemente (22) eine Dornform aufweisen.

2. Das Gehäuse (10) nach Anspruch 1, wobei die Umfangsverbindungsoberflächen (21, 31) parallel zu der Verbindungsrichtung orientiert sind.

3. Das Gehäuse (10) nach einem der vorhergehenden Ansprüche, wobei die Umfangsverbindungsoberfläche (21, 31) eine planare Oberfläche eines der Gehäuseteile (20, 30) ist.

4. Das Gehäuse (10) nach einem der vorhergehenden Ansprüche, wobei die Gehäuseteile (20, 30) aus Aluminium, vorzugsweise aus Druckgussaluminium, hergestellt sind.

5. Das Gehäuse (10) nach einem der vorhergehenden Ansprüche, wobei die Schneidelemente (22) eine Länge zwischen 2 mm und 20 mm aufweisen.

6. Das Gehäuse (10) nach einem der vorhergehenden Ansprüche, wobei die Schneidelemente (22) entlang der Umfangsverbindungsoberflächen (21, 31) äquidistant sind.

7. Das Gehäuse (10) nach einem der vorhergehenden Ansprüche, wobei die Schneidelemente (22) durch einen Abstand von nicht mehr als 50 mm voneinander beabstandet sind.

8. Ein Verfahren zum Montieren eines Gehäuses (10) nach einem der vorhergehenden Ansprüche, um mindestens eine elektronische Komponente eines Kraftfahrzeugs zu umhüllen, die mindestens ein erstes Gehäuseteil (20) mit einer ersten Umfangsverbindungsoberfläche (21) und ein zweites Gehäuseteil (30) mit einer zweiten Umfangsverbindungsoberfläche (31) umfasst, wobei das Verfahren das Verbinden der Gehäuseteile (20, 30) in der Weise umfasst, dass sich die Umfangsverbindungsoberflächen (21, 31) in dem verbundenen Zustand jeweils gegenüberliegend berühren, wobei mindestens eines der Gehäuseteile (20, 30) mehrere Schneidelemente (22) umfasst, die während der Verbindung in die Oberfläche der entsprechenden anderen Umfangsverbindungsoberfläche (21, 31) des anderen Gehäuseteils (20, 30) ritzen.

## Revendications

1. Un boîtier (10) destiné à renfermer au moins un composant électronique d'un véhicule automobile, comprenant au moins une première partie de boîtier métallique (20) avec une première surface de raccordement circonférentielle (21) et une seconde partie de boîtier métallique (30) avec une seconde surface de raccordement circonférentielle (31), dans lequel lesdites parties de boîtier métalliques (20, 30) sont conçues pour être raccordées l'une à l'autre le long d'une direction de raccordement de telle sorte que lesdites surfaces de raccordement circonférentielles (21, 31) se trouvent face à face l'une par rapport à l'autre dans l'état raccordé,
dans lequel au moins une des parties de boîtier (20) comprend une pluralité d'éléments coupants (22) dépassant de la surface de raccordement circonférentielle correspondante (21), dans lequel au moins une partie desdits éléments coupants (22) présente une surdimension par rapport à ladite autre surface de raccordement circonférentielle (31), de telle sorte que lesdits éléments coupants (22) entaillent ladite autre surface de raccordement circonférentielle (31) pendant le raccordement des parties de boîtier (20, 30), dans lequel ladite pluralité d'éléments coupants (22) sont répartis sur la circonférence desdites surfaces de raccordement circonférentielles (21, 31),
dans lequel lesdits éléments coupants (22) ont un axe longitudinal (23) orienté parallèlement à ladite direction de raccordement, dans lequel les éléments coupants (22) ont une épaisseur maximale qui est supérieure à un espace entre les surfaces de raccordement circonférentielles (21, 31) dans l'état raccordé des parties de boîtier (20, 30),
dans lequel lesdits éléments coupants (22) sont agencés à une distance d'un bord avant (24) de la partie de boîtier correspondante (20) qui entre en premier en contact avec ladite autre partie de boîtier (30) pendant le raccordement des parties de boîtier (20, 30),
et chaque élément coupant comporte une partie avant (25) et une partie arrière (26), la partie avant (25) présente une taille inférieure par rapport à la surface de raccordement circonférentielle (31) de la seconde partie de boîtier métallique (30) et la partie arrière (26) présente une surdimension par rapport à la surface de raccordement circonférentielle (31) de la seconde partie de boîtier métallique (30),
dans lequel les éléments coupants (22) sont effilés dans la direction de raccordement dans une vue le long de la surface de raccordement circonférentielle correspondante (21),
**caractérisé en ce que**
les éléments coupants (22) sont effilés dans la direction de raccordement dans une vue sur la surface de raccordement circonférentielle correspondante (21) et les éléments coupants (22) ont une forme de pointe.

2. Le boîtier (10) selon la revendication 1, dans lequel lesdites surfaces de raccordement circonférentielles (21, 31) sont orientées parallèlement à ladite direction de raccordement.

3. Le boîtier (10) selon l'une quelconque des revendications précédentes, dans lequel ladite surface de raccordement circonférentielle (21, 31) est une surface plane de l'une des parties de boîtier (20, 30).

4. Le boîtier (10) selon l'une quelconque des revendications précédentes, dans lequel lesdites parties de boîtier (20, 30) sont en aluminium, de préférence en aluminium moulé sous pression.

5. Le boîtier (10) selon l'une quelconque des revendications précédentes, dans lequel lesdits éléments coupants (22) ont une longueur comprise entre 2 mm et 20 mm.

6. Le boîtier (10) selon l'une quelconque des revendications précédentes, dans lequel lesdits éléments coupants (22) sont équidistants le long desdites surfaces de raccordement circonférentielles (21, 31).

7. Le boîtier (10) selon l'une quelconque des revendications précédentes, dans lequel lesdits éléments coupants (22) sont espacés les uns des autres d'une distance ne dépassant pas 50 mm.

8. Un procédé de montage d'un boîtier (10) selon l'une quelconque des revendications précédentes pour renfermer au moins un composant électronique d'un véhicule automobile comprenant au moins une première partie de boîtier (20) avec une première surface de raccordement circonférentielle (21) et une seconde partie de boîtier (30) avec une seconde surface de raccordement circonférentielle (31), comprenant le raccordement desdites parties de boîtier (20, 30) de telle sorte que les surfaces de raccordement circonférentielles (21, 31) sont en contact l'une avec l'autre face à face dans l'état raccordé, dans lequel au moins l'une des parties de boîtier (20, 30) comprend une pluralité d'éléments coupants (22) qui entaillent la surface de l'autre surface de raccordement circonférentielle correspondante (21, 31) de l'autre partie de boîtier (20, 30) lors du raccordement.
